(19) **Europäisches Patentamt**
**European Patent Office**
**Office européen des brevets**

(11) **EP 2 798 676 B1**

(12) **EUROPEAN PATENT SPECIFICATION**

(45) Date of publication and mention
of the grant of the patent:
**15.03.2017 Bulletin 2017/11**

(51) Int Cl.:
**H01L 31/032** (2006.01)

(21) Application number: **12826634.3**

(22) Date of filing: **21.12.2012**

(86) International application number:
**PCT/JP2012/008183**

(87) International publication number:
**WO 2013/099180 (04.07.2013 Gazette 2013/27)**

(54) **PHOTOVOLTAIC CONVERSION DEVICE AND METHOD OF MANUFACTURING PHOTOVOLTAIC CONVERSION MATERIAL**

FOTOVOLTAISCHE UMWANDLUNGSVORRICHTUNG UND VERFAHREN ZUR HERSTELLUNG EINES FOTOVOLTAISCHEN UMWANDLUNGSMATERIALS

DISPOSITIF DE CONVERSION PHOTOVOLTAÏQUE ET PROCÉDÉ DE FABRICATION DE MATÉRIAU DE CONVERSION PHOTOVOLTAÏQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.12.2011 JP 2011282665**
**27.11.2012 JP 2012259139**

(43) Date of publication of application:
**05.11.2014 Bulletin 2014/45**

(73) Proprietor: **Kabushiki Kaisha Toyota Chuo Kenkyusho**
**Nagakute-shi, Aichi 480-1192 (JP)**

(72) Inventors:
• **OGAWA, Shunsuke**
**Nagakute-shi**
**Aichi 480-1192 (JP)**
• **UMEHARA, Mitsutaro**
**Nagakute-shi**
**Aichi 480-1192 (JP)**

• **TAKEDA, Yasuhiko**
**Nagakute-shi**
**Aichi 480-1192 (JP)**

(74) Representative: **Kramer Barske Schmidtchen Patentanwälte PartG mbB**
**European Patent Attorneys**
**Landsberger Strasse 300**
**80687 München (DE)**

(56) References cited:
**US-A1- 2011 303 879**

• **DATABASE WPI Week 200920 Thomson Scientific, London, GB; AN 2009-F87503 XP002695295, -& CN 101 330 110 A (UNIV CENT SOUTH CHINA) 24 December 2008 (2008-12-24)**
• **MARUSHKO L P ET AL: "Quasi-ternary system Cu2GeS3-Cu2SnS3-CdS", JOURNAL OF ALLOYS AND COMPOUNDS, ELSEVIER SEQUOIA, LAUSANNE, CH, vol. 484, no. 1-2, 18 September 2009 (2009-09-18), pages 147-153, XP026586414, ISSN: 0925-8388, DOI: 10.1016/J.JALLCOM.2009.04.128 [retrieved on 2009-05-03]**

## Description

Technical Field

The present invention relates to a photovoltaic conversion device and a method of manufacturing a photovoltaic conversion material. In particular, the invention relates to a photovoltaic conversion device using a novel photovoltaic conversion material including a $Cu_2Ge_{1-x}Sn_xS_3$-based compound ($0.7 < x < 1$) and a method of manufacturing a photovoltaic conversion material formed of a Cu-Ge-S based compound.

Background Art

A photovoltaic conversion device refers to a device that can convert photon energy to electric energy through a certain physical phenomenon (photovoltaic conversion). Solar cells, which are a type of the photovoltaic conversion device, can efficiently convert the energy of the solar illumination to electric energy.

Single-crystal Si, polycrystalline Si, amorphous Si, GaAs, InP, CdTe, $CuIn_{1-x}Ga_xSe_2$ (CIGS), and $Cu_2ZnSnS_4$ (CZTS) are known as the semiconductors used for the solar cells.

Among them, the chalcogenide compounds typified by CIGS and CZTS can each be formed into a cost-advantageous thin film due to the large light absorbing coefficient thereof. In particular, a solar cell with CIGS as a light absorbing layer has a relatively high conversion efficiency among thin-film solar cells, and has exhibited a conversion efficiency higher than that of a polycrystalline-Si solar cell (see Non Patent Literature 1).

The spectrum of the sunlight is widely distributed from ultraviolet rays to infrared rays. A light absorbing layer, however, can absorb only photons each having energy larger than the bandgap of a material forming the light absorbing layer. In addition, even if a photon having energy larger than the bandgap is absorbed, the energy in excess of the bandgap dissipates as heat; hence, the output voltage necessarily has a value corresponding to the bandgap. As a result, as the bandgap of the light absorbing layer increases, the output voltage of the solar cell increases, but the current decreases due to a decrease in number of absorbed photons. In contrast, as the bandgap of the light absorbing layer decreases, the current increases due to an increase in number of absorbed photons, but the output voltage decreases.

In other words, a solar cell (single-junction solar cell) having a light absorbing layer formed of one material has a trade-off relationship between current and voltage. As a result, for example, either conversion efficiencies of a nano-crystalline silicon single-junction solar cell and an amorphous-silicon single-junction solar cell have made no significant progress for over a decade (see Non Patent Literature 2).

Furthermore, the CIGS single-junction solar cells are expensive due to In, which is a rare metal, included therein. The bandgap of CIGS can be adjusted through adjustment of the elemental ratio between In and Ga. The CIGS single-junction solar cell, however, disadvantageously exhibits a low conversion efficiency for a Ga-rich state giving a wide bandgap while exhibiting a high conversion efficiency for an In-rich state giving a narrow bandgap.

To solve such a problem, there is proposed a multi-junction solar cell including stacked light absorbing layers having different bandgaps. As the multi-junction solar cell, for example, the following solar cells are currently commercially available:

(a) nanocrystalline silicon/amorphous silicon double-junction solar cells, and
(b) amorphous silicon-germanium/amorphous silicon double-junction solar cells.

The bandgaps of the light absorbing layers must be adjusted in order to achieve a high conversion efficiency of the multi-junction solar cell. In case of producing the multi-junction solar cell, it may cause an increase in production cost that materials having entirely different compositions or materials produced by entirely different process are used as materials having different bandgaps. Hence, a material that can be appropriately controlled from a high-current/low-voltage material to a low-current/high-voltage material is preferred as the material forming the light absorbing layers of the multi-junction solar cell.

Furthermore, if a light absorbing layer has a pinhole, a conversion efficiency of the photovoltaic conversion device is reduced.

Citation List

Non Patent Literature

NPL 1: T. Eisenbarth et al., Thin Solid Films, 517(2009)2244.

NPL 2: A/Luque, J.Appl.Phys., 110(2011)031301.

CN 101 330 110 A relates to a light absorption layer material of a thin film solar cell, wherein the light absorption layer material adopts a $Cu_2Si_xSn_{1-x}S_3$ semiconductor film or a $Cu_2Ge_xSn_{1-x}S_3$ semiconductor film (x is equal to 0 to 1) in $Cu_2MS_3$ (M is Si, Ge or Sn) serial compounds.

US 2011/0303879 A1 relates to a sulfide comprising Cu, Zn and Sn as a principal component, wherein, when x is a ratio of Cu(Zn+Sn), y is a ratio of Zn/Sn (x and y being atomic ratios), and a composition of the sulfide is represented by the (x, y) coordinates, with points A = (0.78, 1.32), B = (0.86, 1.32), C = (0.86, 1.28), D = (0.90, 1.23), E = (0.90, 1.18), and F = (0.78, 1.28), the composition (x, y) of the sulfide is on any one of respective straight lines connecting the points A→B→C→D→E→F→A in that order, or within an area enclosed by the respective straight lines.

Summary of Invention

Technical Problem

A problem that the invention is to solve is to provide a novel method of manufacturing a photovoltaic conversion material that can be appropriately controlled from a high-current/low-voltage material to a low-current/high-voltage material, and a photovoltaic conversion device using the photovoltaic conversion material as a light absorbing layer.

Another problem that the invention is to solve is to provide a method of manufacturing a thin film with few pinholes formed in a novel photovoltaic conversion material, and a photovoltaic conversion device using the photovoltaic conversion material as a light absorbing layer.

Solution to Problem

To solve the above-described problems, a photovoltaic conversion device according to the invention comprises a light absorbing layer, all or part of which includes a $Cu_2Ge_{1-x}Sn_xS_3$-based compound, wherein x is 0.7 < x < 1.

A method of manufacturing a photovoltaic conversion material according to the invention comprises:

preparing a Cu-based precursor;

generating a vapor containing S and Ge from an S source and a Ge source; and

reacting the vapor with the Cu-based precursor to synthesize a photovoltaic conversion material including Cu-Ge-S based compound, wherein the Ge source is a powder or a thin film of one or more materials selected from GeS and $GeS_2$.

Preferably, a Cu-Ge based precursor, a Cu-Sn based precursor or a Cu-Ge-Sn based precursor is used as the Cu-based precursor.

Advantageous Effects of Invention

The $Cu_2Ge_{1-x}Sn_xS_3$-based compound has a narrower bandgap with an increase in x. As a result, any of materials from a high-current/low-voltage material to a low-current/high-voltage material can be appropriately produced through control of the Sn content (x).

In addition, the vapor containing S and Ge is reacted with the Cu-based precursor for synthesis of the $Cu_2Ge_{1-x}Sn_xS_3$-based compound, thus allowing synthesis of a light absorbing layer with few pinholes formed in the $Cu_2Ge_{1-x}Sn_xS_3$-based compound.

Brief Description of Drawings

Fig. 1 is a schematic sectional view illustrating an exemplary structure of a photovoltaic conversion device.

Fig. 2 is a schematic sectional view of a reactor for manufacturing a photovoltaic conversion material according to the present invention.

Fig. 3 is a graph illustrating external quantum efficiencies of photovoltaic conversion devices using $Cu_2Ge_{1-x}Sn_xS_3$ (x=0.059, 0.214, and 0.832) as light absorbing layers.

Fig. 4 is a graph illustrating current-voltage characteristics of photovoltaic conversion devices using $Cu_2Ge_{1-x}Sn_xS_3$ (x=0.832 and 1.000) as light absorbing layers.

Fig. 5 is a graph illustrating a result of pinhole test which compares light absorbing layers (Samples No. 2 to No. 4) sulfurized with vapor containing sulfur and Ge with light absorbing layers (Samples No. 6 to No. 8) sulfurized with vapor containing only sulfur.

Description of Embodiments

Hereinafter, an embodiment of the present invention will be described in detail.

(1. Photovoltaic Conversion Device)

A photovoltaic conversion device according to the invention includes a light absorbing layer, all or part of which includes a $Cu_2Ge_{1-x}Sn_xS_3$-based compound, wherein x is 0.7<x<1.

(1.1. Light Absorbing Layer)

(1.1.1. $Cu_2Ge_{1-x}Sn_xS_3$-based compound)

The light absorbing layer includes a $Cu_2Ge_{1-x}Sn_xS_3$-based compound, wherein x is 0.7 <x<1.

The <$Cu_2Ge_{1-x}Sn_xS_3$-based compound> refers to a sulfide-based compound semiconductor containing Cu, Ge, Sn, and S as essential components. The elemental ratio of the $Cu_2Ge_{1-x}Sn_xS_3$ is formally given as Cu:(Ge+Sn):S=2:1:3. The <$Cu_2Ge_{1-x}Sn_xS_3$-based compound> in the invention, however, includes not only the stoichiometric compound but also compounds with a slight deviation from the stoichiometric composition as long as the compounds can be regarded to be substantially identical to $Cu_2Ge_{1-x}Sn_xS_3$. The <substantially identical> means that the deviation of Cu/(Sn+Ge) ratio from the stoichiometric composition is within a range of plus or minus 20%. Preferably, the deviation from the stoichiometric composition is within a range of plus or minus 10%.

(1.1.2.x)

Here, <x> represents Sn/(Ge+Sn) ratio. The bandgap of $Cu_2GeS_3$ is about 1.55 eV, while the bandgap of $Cu_2SnS_3$ is about 0.90 eV. As a result, the $Cu_2Ge_{1-x}Sn_xS_3$-based compound has a smaller bandgap with an increase in x. Specifically, the bandgap of the $Cu_2Ge_{1-x}Sn_xS_3$-based compound can be appropriately controlled from about 0.90 eV to about 1.55 eV through control of x. According to the present invention, x is 0.7 < x < 1.

The $Cu_2Ge_{1-x}Sn_xS_3$-based compound may include Li, Na, K, Mg, Ca, Ag, Zn, Cd, Al, Ga, In, Si, Pb, Sb, Bi, Se, Te or the like for the purpose of suppression of lattice defects, control of the bandgap, control of carrier concentration or the like.

(1.1.3 Structure of Light Absorbing Layer)

The $Cu_2Ge_{1-x}Sn_xS_3$-based compound may either entirely or partially form the light absorbing layer.

Specifically, the light absorbing layer may include any one of

(1) only a $Cu_2Ge_{1-x}Sn_xS_3$-based compound having one composition (single-junction photovoltaic conversion device),
(2) a stack of two or more $Cu_2Ge_{1-x}Sn_xS_3$-based compound layers having different compositions (multi-junction photovoltaic conversion device), and
(3) a stack of one or more $Cu_2Ge_{1-x}Sn_xS_3$-based compound layers having different compositions and another compound layer (multi-junction photovoltaic conversion device).

For example, it is known that a double-junction solar cell, which includes two materials having different bandgaps of about 1.8 eV and 1.1 eV as first and second layers from an incident side of the sunlight, exhibits the maximum conversion efficiency among double-junction solar cells. In such a case, the $Cu_2Ge_{1-x}Sn_xS_3$-based compound according to the invention is preferred as the second-layer material.

In addition, for example, it is known that a triple-junction solar cell, which includes three materials having different bandgaps of about 2.2 eV, 1.4 eV, and 0.9 eV as first, second, and third layers from an incident side of the sunlight, exhibits the maximum conversion efficiency among triple-junction solar cells. In such a case, the $Cu_2Ge_{1-x}Sn_xS_3$-based compound according to the invention is preferred as a material for the second and third layers.

(1.1.4. Pinhole and Peeling Resistance)

The light absorbing layer configuring the photovoltaic conversion device according to the invention is synthesized by a process described later, leading to few pinholes and excellent peeling resistance of the light absorbing layer compared with a light absorbing layer synthesized by another process.

(1.2. Other Layers)

The photovoltaic conversion device commonly includes layers other than the light absorbing layer. The stacked structure of the device and a material forming each layer is not limited and may be optimally selected depending on a type of the photovoltaic conversion device.

For example, a solar cell commonly has a structure where a bottom electrode, a light absorbing layer, a buffer layer, a window layer, and a grid electrode are provided in this order on a substrate.

In the case where the photovoltaic conversion device serves as a solar cell, materials for the layers other than the light absorbing layer include the following.

Examples of the material for the substrate include glass (for example, SLG, low-alkali glass, non-alkali glass, quartz glass, Na-ion implanted quartz glass, and sapphire glass), ceramics (for example, oxides such as silica, alumina, yttria, and zirconia, and various ceramics containing Na), and metal (for example, stainless steel, stainless steel containing Na, Au, Mo, and Ti).

Examples of the material for the bottom electrode include Mo, $MoSi_2$, stainless steel, In-Sn-O, In-Zn-O, ZnO: Al, ZnO: B, $SnO_2$: F, $SnO_2$: Sb, ZnO: Ga, and $TiO_2$: Nb.

Examples of the material for the buffer layer include CdS, Zn(O, S), and (Zn, Mg)O.

Examples of the material for the window layer include ZnO: Al, ZnO: Ga, ZnO: B, In-Sn-O, In-Zn-O, $SnO_2$: Sb, and $TiO_2$: Nb.

Examples of the material for the grid electrode include Al, Cu, Ag, and Au, and alloy including one or more of them. Such alloy specifically includes Al-Ti alloy, Al-Mg alloy, Al-Ni alloy, Cu-Ti alloy, Cu-Sn alloy, Cu-Zn alloy, Cu-Au alloy, Ag-Ti alloy, Ag-Sn alloy, Ag-Zn alloy, and Ag-Au alloy.

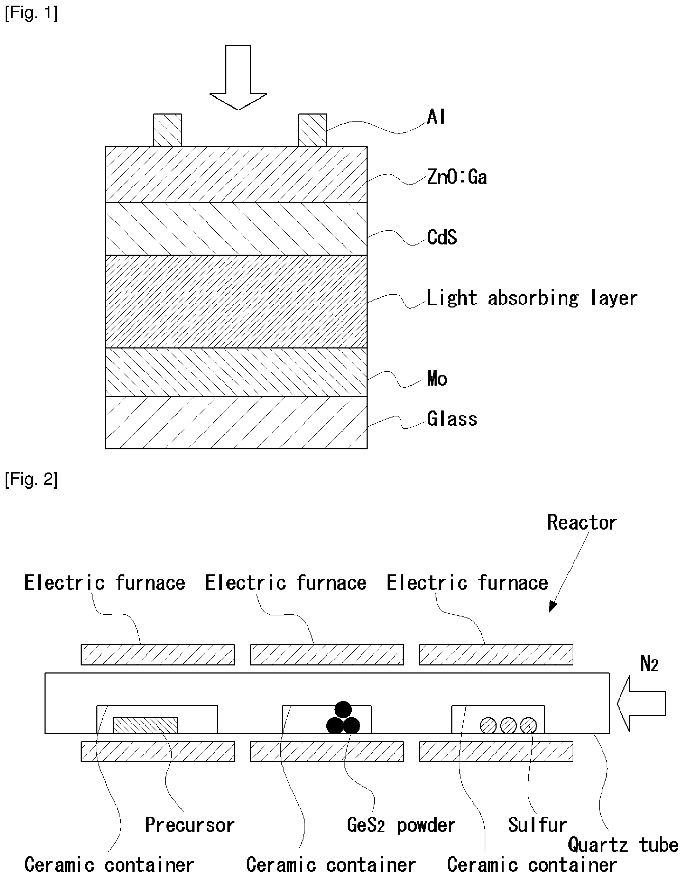

Fig. 1 illustrates a schematic sectional view of a solar cell as a type of the photovoltaic conversion device. In Fig. 1, the solar cell includes Mo, a light absorbing layer, CdS, ZnO: Ga, and an Al grid electrode in this order on a glass substrate. All or part of the light absorbing layer includes the $Cu_2Ge_{1-x}Sn_xS_3$-based compound.

Furthermore, an additional layer (for example, an adhesive layer for improving adhesion between the substrate and the bottom electrode, a light scattering layer, and an antireflection layer) may be provided between the layers.

(2. Method of Manufacturing Photovoltaic Conversion Material)

A method of manufacturing the photovoltaic conversion material according to the invention includes a precursor preparation step, a vapor generation step, and a reaction step.

(2.1. Precursor Preparation Step)

In the precursor preparation step, a Cu-based precursor is prepared.

In the invention, the Cu-based precursor is used as a precursor to synthesize a Cu-Ge-S based compound.

The <Cu-Ge-S based compound> refers to a compound containing at least Cu, Ge, and S. The Cu-Ge-S based compound may further contain Sn. Examples of the Cu-Ge-S based compound include the $Cu_2Ge_{1-x}Sn_xS_3$-based compound, wherein x is $0.7 < x < 1$.

The <Cu-based precursor> refers to a precursor containing at least Cu. The Cu-based precursor containing two or more elements may be an alloy with a single composition or a mixture containing two or more elements or alloys.

Examples of the Cu-based precursor include:

(a) Cu,
(b) a Cu-Ge based precursor which includes at least Cu and Ge (for example, a Cu-Ge compound such as $Cu_3Ge$, or a Cu-Ge alloy),
(c) a Cu-Sn based precursor which includes at least Cu and Sn (for example, a Cu-Sn compound such as $Cu_6Sn_5$, $Cu_3Sn$, or $Cu_{10}Sn_3$, or a Cu-Sn alloy),
(d) a Cu-Ge-Sn based precursor which includes at least Cu, Ge, and Sn (for example, a mixture of a Cu-Ge compound such as $Cu_3Ge$ and a Cu-Sn compound such as $Cu_6Sn_5$, $Cu_3Sn$, or $Cu_{10}Sn_3$, a mixture of the Cu-Ge compound and the Cu-Sn alloy, a mixture of the Cu-Ge alloy and the Cu-Sn compound, or a Cu-Ge-Sn alloy), and
(e) a mixture containing any two or more materials from (a) to (d).

The Cu-based precursor may further contain a part of S which should be supplied in the reaction step described later.

A precursor having a $Cu_2Sn$ composition is heated under an S-containing atmosphere, thus allowing $Cu_2SnS_3$ to be relatively readily synthesized. In contrast, a precursor having a $Cu_2Ge$ composition is heated under an S-containing atmosphere, which, however, does not allow preparation of $Cu_2GeS_3$ with few pinholes. The reason for this is speculated as follows. That is, the Cu-Ge binary system has no $Cu_2Ge$ phase. Therefore, $Cu_2Ge$ is decomposed into a $Cu_3Ge$ phase and a Ge phase, and the Ge phase readily vaporizes during the heating process.

Thus, in the invention, a Cu-based precursor is used as the precursor, and the precursor is sulfurized while Ge is externally added, in order to prevent Ge from vaporizing in the case where Ge is included in the precursor, and to compensate the insufficiency to predetermined Ge composition of the Cu-Ge-S based compound to be synthesized. The method of the invention is different from typical methods in this point.

To synthesize the Cu-Ge-S compound containing Sn in any appropriate proportion (x) (that is, $Cu_2Ge_{1-x}Sn_xS_3$-based compound, wherein x is $0.7 < x < 1$), the elemental ratio of Cu, Ge and Sn in the Cu-based precursor must meet the following formulas in general.

$$Cu/(Ge+Sn)>2,$$

and

$$Sn/(Ge+Sn)>x.$$

As described above, the $Cu_2Ge_{1-x}Sn_xS_3$-based compound to be synthesized includes not only the stoichiometric compound but also compounds with a slight deviation from the stoichiometric composition. Specifically, it includes compounds which have Cu/(Sn+Ge) ratio deviated from the stoichiometric composition within a range of plus or minus 20%. That is, it includes compounds which have a composition of $1.6<Cu/(Sn+Ge)<2.4$.

Therefore, the Cu-based precursor used for synthesis of the compound may be accompanied by the deviation from the stoichiometric composition similar to the compound. That is, the Cu-based precursor used for synthesis of the compound includes a precursor having a composition of $1.6<Cu/(Ge+Sn)$.

The configuration of the precursor is not limited and may be any one of a mass, powder, and a thin film.

The Cu-Sn based precursor having a composition of $1.6<Cu/Sn$ is preferred as the Cu-based precursor. By reacting a vapor containing S and Ge with the Cu-Sn based precursor, $Cu_2Ge_{1-x}SnS_3$-based compound $(0.7<x<1)$ may be obtained.

Furthermore, the Cu-Ge-Sn based precursor having a composition of $1.6<Cu/(Ge+Sn)$ and $0.7<Sn/(Ge+Sn)$ is preferred as the Cu-based precursor. By reacting a vapor containing S and Ge with the Cu-Ge-Sn based precursor, $Cu_2Ge_{1-x}SnS_3$-based compound $(0.7<x<1)$ may be obtained.

The Cu-based precursor may include Li, Na, K, Mg, Ca, Ag, Zn, Cd, Al, Ga, In, Si, Pb, Sb, Bi, Se, Te or the like for the purpose of suppression of lattice defects, control of the bandgap, control of carrier concentration or the like.

The Cu-based precursor for synthesis of the $Cu_2Ge_{1-x}SnS_3$-based compound should have an overall composition equal or equivalent to $Cu/(Ge+Sn)>2$ and $Sn/(Ge+Sn)>x$, but may have any internal structure.

For example, the Cu-based precursor may be formed of a Cu-Ge-Sn thin film deposited by a co-sputter process, or may be formed of stacked films deposited by sputter in a plurality of steps with multiple targets.

If the Cu-based precursor having free Ge is directly heated to a sulfurization temperature, the free Ge may vaporize. In such a case, the Cu-based precursor is preferably preheated before sulfurization of the Cu-based precursor to induce generation of $Cu_3Ge$ from the free Ge.

(2.2. Vapor Generation Step)

In the vapor generation step, a vapor containing S and Ge is generated from an S source and a Ge source.

(2.2.1. S source and Ge source)

The S and Ge sources for generation of the vapor should be sources that allow generation of a vapor containing sufficient amounts of S and Ge to synthesize a $Cu_2Ge_{1-x}Sn_xS_3$-based compound with few defects.

Examples of the S source include S powder, GeS, and $GeS_2$. Among them, S powder is preferred as the S source since it allows generation of a large amount of an S vapor through low-temperature heating.

The Ge source is a powder or a thin film of one or more materials selected from GeS and $GeS_2$.

Each of the S and Ge sources may be used alone, or two or more sources may be used in combination.

The configuration of the S source is not limited and may be any one of a mass, powder, and a thin film. In particular, S powder is preferred as the S source since it readily vaporizes.

(2.2.2. Generation of Vapor)

Any method of vapor generation may be used as long as the method allows generation of the vapor containing predetermined amounts of S and Ge.

For example, if the vapor containing predetermined amounts of S and Ge can be generated by heating the S source and the Ge source at the same temperature, the S and Ge sources should be heated at the same temperature. In this case, the S source and the Ge source may be placed away from each other, or may be placed adjacent to each other.

In contrast, if the S source and the Ge source, which have significantly different vaporization temperatures, are heated at the same temperature, the content of each of S and Ge in the vapor is difficult to be controlled. In such a case, the S source and the Ge source are preferably placed away from each other to heat each source at the optimum temperature.

For example, in the case where S powder and $GeS_2$ are used as the S and Ge sources, respectively, the vaporization temperature of the S powder is lower than that of $GeS_2$. In such a case, the S powder and $GeS_2$ are preferably independently heated at different temperatures.

Each concentration of S and Ge in the vapor should be equal to or higher than the minimum concentration to convert the precursor to the $Cu_2Ge_{1-x}Sn_xS_3$-based compound.

$Cu_2GeS_3$ is the sulfide having the maximum Ge content in the Cu-Ge-S system. Hence, even if the precursor is reacted with the vapor containing excessive S and Ge, no heterogeneous phase is generated.

(2.3. Reaction Step)

In the reaction step, the vapor produced in the vapor generation step is reacted with the Cu-based precursor to synthesize the photovoltaic conversion material including Cu-Ge-S based compound. That is, the method of the invention is applied to producing a $Cu_2Ge_{1-x}Sn_xS_3$-based compound, wherein x is $0.7 < x < 1$.

(2.3.1. Reaction Process)

In the case where each vaporization temperature of the S and Ge sources is similar to the reaction temperature between the precursor and the vapor, the S source, the Ge source, and the precursor should be heated at the same temperature. In this case, the S source, the Ge source, and the precursor may be placed away from one another, or may be placed adjacent to one another.

In contrast, one or more of the vaporization temperatures and the reaction temperature is significantly different from others, the corresponding one or more of the S source, the Ge source, and the precursor are preferably placed away from the others so as to be heated at a different temperature.

(2.3.2. Reactor)

Fig. 2 illustrates an exemplary reactor for manufacturing the photovoltaic conversion material according to the invention.

In Fig. 2, the reactor (three-zone reactor) includes a quartz tube and three electric furnaces. The quartz tube holds the S source, the Ge source, and the precursor, and supplies the vapors generated from the S and Ge sources to the precursor. The quartz tube is designed to allow flow of a carrier gas ($N_2$) from one end to the other end thereof.

The first ceramic container in which the S source (sulfur) is put, the second ceramic container in which the Ge source ($GeS_2$) is put, and the third ceramic container in which the precursor is put, are located in this order from the upstream side of the quarts tube to the downstream side. $GeS_2$ and the precursor may be put in the same ceramic container. That is, the heating of the low materials may be done by using a reactor (two-zone reactor) having two electric furnaces. This is because the vaporization temperature of $GeS_2$ is close to the reaction temperature between the precursor and the vapor. In contrast, sulfur is preferably placed away from the others, because the vaporization temperature of sulfur is lower than the vaporization temperature of $GeS_2$ and the reaction temperature. An electric furnace is placed around each ceramic container so that temperature of each ceramic container can be independently controlled.

The electric furnaces are heated while the carrier gas is flowed into the quartz tube. Thus, an S vapor is first generated from the sulfur in the electric furnace on the upstream side and is carried to the downstream side. Then, $GeS_2$ vaporizes in the middle point, so that the vapor containing S and Ge is formed. Finally, the vapor reacts with the precursor to synthesize the $Cu_2Ge_{1-x}Sn_xS_3$-based compound at the downstream side.

(3. Effects)

The $Cu_2Ge_{1-x}Sn_xS_3$-based compound has a narrower bandgap with an increase in x. As a result, any material from a high-current/low-voltage material to a low-current/high-voltage material can be arbitrarily produced through control of the Sn content (x).

If an S vapor is reacted with the Cu-based precursor in an atmosphere not to include Ge vapor for synthesis of a thin film including $Cu_2Ge_{1-x}Sn_xS_3$-based compound, wherein x is 0.7 < x < 1, a pinhole is formed in the thin film, or the thin film is peeled from a substrate.

In contrast, if the vapor containing S and Ge is reacted with the Cu-based precursor for formation of the $Cu_2Ge_{1-x}Sn_xS_3$-based compound, the $Cu_2Ge_{1-x}Sn_xS_3$-based compound with few pinholes can be formed. The reason for this is assumed to be due to sufficient reaction between the Cu-based precursor and Ge, or suppression of vaporization of Ge from the Cu-based precursor in the case where the Cu-based precursor includes Ge.

In the following, samples wherein x is outside the range of 0.7 < x < 1 are provided for comparative purposes only.

Examples

(Samples No. 1 to No. 5)

(1. Production of Photovoltaic Conversion Devices)

Single-junction photovoltaic conversion devices, each of which includes a Mo layer, a light absorbing layer, a CdS layer, a ZnO: Ga layer, and an A1 grid electrode in this order on glass, were produced.

The light absorbing layers ($Cu_2Ge_{1-x}Sn_xS_3$) were prepared in the reactor (three-zone reactor) illustrated in Fig. 2. Five kinds of precursors of $Cu_2Ge_{0.667}$ for Sample No. 1, $Cu_2Ge_{0.632}Sn_{0.059}$ for Sample No. 2, $Cu_2Ge_{0.518}Sn_{0.214}$ for Sample No. 3, $Cu_2Sn_{0.847}$ for Sample No. 4, and $Cu_2Sn$ for Sample No. 5 were used as Cu-based precursors. For Samples No. 1 to No. 4, the vapor containing S and Ge was reacted with the precursors. For Sample No. 5, the vapor of S was reacted with the precursor. In this case, nothing was put in the second ceramic container. As a result, composition x of the obtained thin film including $Cu_2Ge_{1-x}SnxS_3$-based compound was 0.000 for Sample No. 1, 0.059 for Sample No. 2, 0.214 for Sample No. 3, 0.832 for Sample No. 4, and 1.000 for Sample No. 5.

(2. Test Method and Results)

(2.1. External Quantum Efficiency)

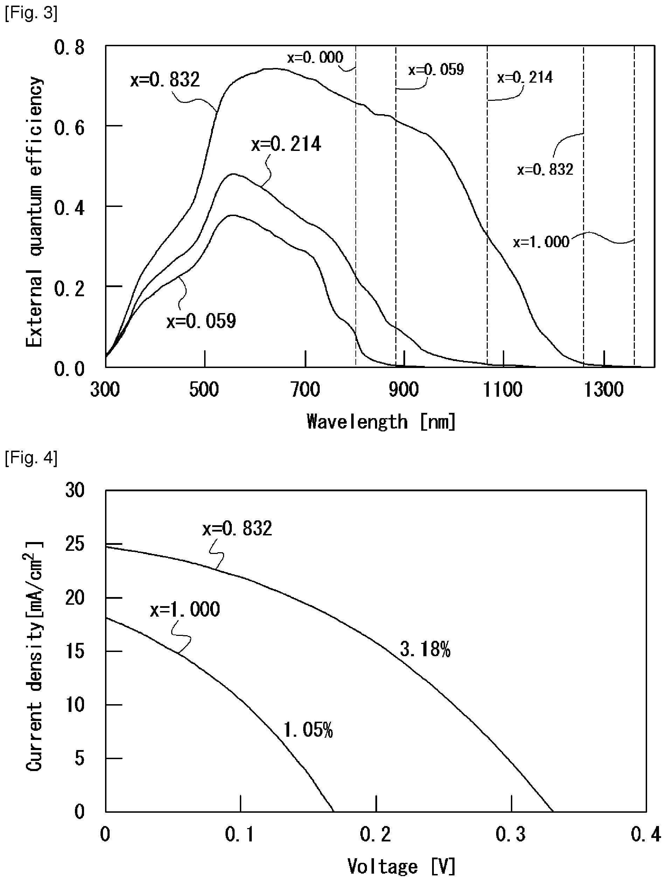

The external quantum efficiency of each photovoltaic conversion device was measured. Fig. 3 illustrates the external quantum efficiencies of the photovoltaic conversion devices using $Cu_2Ge_{1-x}Sn_xS_3$ (x=0.059, 0.214, and 0.832) as the light absorbing layers. Fig. 3 also illustrates a rising position of each absorption edge at x=0, 0.059, 0.214, 0.832, and 1.000.

The rising positions of the absorption edges reveal that the bandgap can be adjusted. Specifically, Fig. 3 shows that the bandgap can be adjusted within a range of 1.55 to 0.90 eV through adjustment of x of $Cu_2Ge_{1-x}Sn_xS_3$. Current matching, which is essential for an increase in efficiency of two-terminal multi-junction solar cells, can be readily achieved through use of the $Cu_2Ge_{1-x}Sn_xS_3$-based compound as the light absorbing layer.

(2.2. Current-Voltage Characteristics)

The current-voltage characteristics of the photovoltaic conversion devices were measured. Fig. 4 illustrates the current-voltage characteristics of the photovoltaic conversion device using $Cu_2Ge_{1-x}Sn_xS_3$ (x=0.832). Fig. 4 also illustrates the results of the photovoltaic conversion device using $Cu_2Ge_{1-x}Sn_xS_3$ with x of 1.000. In Fig. 4, each numerical value represents conversion efficiency (%).

Fig. 4 reveals that Ge is added to $Cu_2Sn_xS_3$ (x=1.0) to produce $Cu_2Ge_{1-x}Sn_xS_3$, thereby the conversion efficiency is improved. Further, it reveals that maintaining x in a specific range in case of using CdS as a buffer layer makes not only voltage but also current density of the device improved compared to x=1.000.

The conversion efficiency of $Cu_2GeS_3$ (x=0) may be measured depending on the condition. However, the measurement was not performed because the peeling off of the light absorbing layer from the substrate may occur.

(Samples No. 6 to No. 10)

(1. Preparation of Samples)

(1.1. Samples No. 6 to No. 8)

A thin film including a Cu-Ge-Sn based precursor was formed on a glass substrate. $Cu_2Ge_{0.814}Sn_{0.219}$ for Sample No. 6, $Cu_2Ge_{0.602}Sn_{0.430}$ for Sample No. 7, and $Cu_2Ge_{0.061}Sn_{0.953}$ for Sample No. 8 were used as the Cu-Ge-Sn based precursors. By using the reactor (three-zone reactor) illustrated in Fig. 2, the vapor containing only S was reacted with the precursor to form a $Cu_2Ge_{1-x}Sn_xS_3$ thin film about 1 micrometer in thickness. In this case, nothing was put in the second ceramic container.
As a result, composition x of the obtained thin film including $Cu_2Ge_{1-x}Sn_xS_3$-based compound was 0.219 for Sample No. 6, 0.430 for Sample No. 7, and 0.953 for Sample No. 8.

(1.2. Samples No. 9 and No. 10)

A thin film including a Cu-Ge based precursor (Cu/Ge=3) was formed on a glass substrate. The vapor containing S and Ge was reacted with the precursor to prepare a $Cu_2GeS_3$ thin film about 1 micrometer in thickness (Sample No. 9).
Similarly, a thin film including a Cu-Ge based precursor (Cu/Ge=2) was formed on a glass substrate. The vapor containing only S was reacted with the precursor to prepare a $Cu_2GeS_3$ thin film about 1 micrometer in thickness (Sample No. 10).
Both Sample No. 9 and Sample No. 10 were prepared in the reactor (two-zone reactor) having two electric furnaces. A ceramic container in which the S source (sulfur) was put was placed on the upstream side of the quartz tube, and another ceramic container in which the Ge source ($GeS_2$) and the precursor were put was placed on the downstream side thereof.

(2. Test Method)

Each Sample was irradiated with light from the back of the glass substrate, and leakage light was photographed by a camera, so that 256-grayscale monochrome images were captured. The number of white pixels was counted, the white pixels corresponding to more than the 16th grayscale from deep black among the 256 grayscales. The pinhole level was obtained from formula (1):

$$Pinhole\ level = P/P_0\ *** (1),$$

where P represents a ratio of the number of white pixels to the total pixel number of each Sample, and
Po represents a ratio of the number of white pixels to the total pixel number of Sample with x of 0.059.

(3. Results)

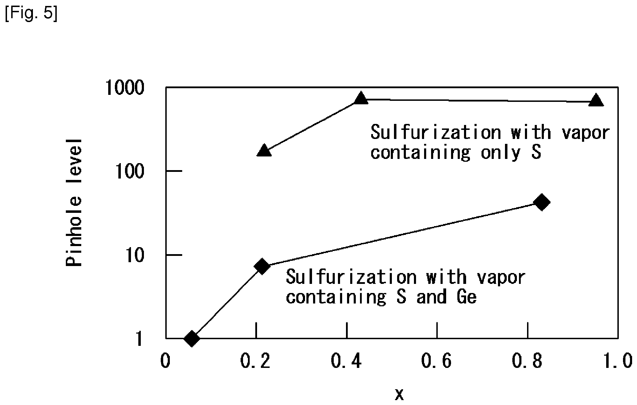

Fig. 5 illustrates a result of pinhole test which compares light absorbing layers (Samples No. 2 to No. 4) sulfurized with vapor containing sulfur and Ge with light absorbing layers (Samples No. 6 to No. 8) sulfurized with vapor containing only sulfur.
Although not shown in drawings, the thin film as Sample No. 9 had five or fewer pinholes per square centimeter. In contrast, the thin film as Sample No. 10 had six to nine pinholes per square centimeter.
Fig. 5, and the results of sample No. 9 and No. 10 reveals that the sulfurization with the vapor containing only sulfur leads to a significant increase in pinhole level. This is most likely due to sublimation of Ge during the sulfurization, causing formation of pinholes. In contrast, a high-quality film with few pinholes is achieved due to suppression of sublimation of Ge through the sulfurization with the vapor containing sulfur and Ge.

Industrial Applicability

The photovoltaic conversion device and the method of manufacturing the photovoltaic conversion material can be used for thin-film solar cells, photoconductive cells, photodiodes, and phototransistors, for example.

**Claims**

1. A photovoltaic conversion device, comprising:

   a light absorbing layer, all or part of the light absorbing layer including a $Cu_2Ge_{1-x}Sn_xS_3$-based compound, **characterised in that** x is such that $0.7 < x < 1$.

2. The photovoltaic conversion device according to claim 1, wherein the photovoltaic conversion device has a stacked structure of a bottom electrode, the light absorbing layer, a buffer layer, a window layer, and a grid electrode.

3. The photovoltaic conversion device according to claim 1, wherein the photovoltaic conversion device has a stacked structure of glass, Mo, the light absorbing layer, CdS, ZnO: Ga, and an A1 grid electrode.

4. A method of manufacturing a photovoltaic conversion material, comprising:

   preparing a Cu-based precursor;
   generating a vapor containing S and Ge from an S source and a Ge source; and
   reacting the vapor with the Cu-based precursor to synthesize a photovoltaic conversion material including Cu-Ge-S based compound, wherein the Ge source is a powder or a thin film of one or more materials selected from GeS and $GeS_2$.

5. The method of manufacturing a photovoltaic conversion material according to claim 4,
   wherein the Cu-based precursor is a Cu-Ge based precursor, a Cu-Sn based precursor, or a Cu-Ge-Sn based precursor.

6. The method of manufacturing a photovoltaic conversion material according to claim 4,
   wherein the Cu-based precursor is a Cu-Sn based precursor having a composition of $1.6 < Cu/Sn$, and
   the Cu-Ge-S based compound is a $Cu_2Ge_{1-x}Sn_xS_3$-based compound having a composition of $0.7<x<1$.

7. The method of manufacturing a photovoltaic conversion material according to claim 4,
   wherein the Cu-based precursor is a Cu-Ge-Sn based precursor having a composition of $1.6 < Cu/(Ge+Sn)$ and $0.7 < Sn/(Ge+Sn)$, and
   the Cu-Ge-S based compound is a $Cu_2Ge_{1-x}Sn_xS_3$-based compound having a composition of $0.7<x<1$.

8. The method of manufacturing a photovoltaic conversion material according to claim 4, wherein the S source is S powder.

**Patentansprüche**

1. Photovoltaische Umwandlungsvorrichtung, umfassend:

   eine lichtabsorbierende Schicht, wobei die gesamte lichtabsorbierende Schicht oder ein Teil der lichtabsorbierenden Schicht eine Verbindung auf $Cu_2Ge_{1-x}Sn_xS_3$-Basis umfasst, **dadurch gekennzeichnet, dass** x derart ist, dass $0,7 < x < 1$ ist.

2. Photovoltaische Umwandlungsvorrichtung nach Anspruch 1, wobei die photovoltaische Umwandlungsvorrichtung eine gestapelte Struktur aus einer unteren Elektrode, der lichtabsorbierenden Schicht, einer Pufferschicht, einer Fensterschicht und einer Gitterelektrode aufweist.

3. Photovoltaische Umwandlungsvorrichtung nach Anspruch 1, wobei die photovoltaische Umwandlungsvorrichtung eine gestapelte Struktur aus Glas, Mo, der lichtabsorbierenden Schicht, CdS, ZnO: Ga und einer Al-Gitterelektrode aufweist.

4. Verfahren zur Herstellung eines photovoltaischen Umwandlungsmaterials, umfassend:

   Herstellen einer Vorstufe auf Cu-Basis,
   Erzeugen eines Dampfs, der S und Ge enthält, aus einer S-Quelle und einer Ge-Quelle, und

Umsetzen des Dampfs mit der Vorstufe auf Cu-Basis zum Synthetisieren eines photovoltaischen Umwandlungsmaterials, das die Verbindung auf Cu-Ge-S-Basis umfasst, wobei die Ge-Quelle ein Pulver oder ein Dünnfilm aus einem oder mehreren Material(ien) ist, das oder die aus GeS und $GeS_2$ ausgewählt ist oder sind.

**5.** Verfahren zur Herstellung eines photovoltaischen Umwandlungsmaterials nach Anspruch 4, bei dem die Vorstufe auf Cu-Basis eine Vorstufe auf Cu-Ge-Basis, eine Vorstufe auf Cu-Sn-Basis oder eine Vorstufe auf Cu-Ge-Sn-Basis ist.

**6.** Verfahren zur Herstellung eines photovoltaischen Umwandlungsmaterials nach Anspruch 4, bei dem die Vorstufe auf Cu-Basis eine Vorstufe auf Cu-Sn-Basis mit der Zusammensetzung 1,6 < Cu/Sn ist und die Verbindung auf Cu-Ge-S-Basis eine Verbindung auf $Cu_2Ge_{1-x}SnxS_3$-Basis mit der Zusammensetzung 0,7 < x < 1 ist.

**7.** Verfahren zur Herstellung eines photovoltaischen Umwandlungsmaterials nach Anspruch 4, bei dem die Vorstufe auf Cu-Basis eine Vorstufe auf Cu-Ge-Sn-Basis mit der Zusammensetzung 1,6 < Cu/(Ge+Sn) und 0,7 < Sn/(Ge+Sn) ist und die Verbindung auf Cu-Ge-S-Basis eine Verbindung auf $Cu_2Ge_{1-x}Sn_xS_3$-Basis mit der Zusammensetzung 0,7 < x < 1 ist.

**8.** Verfahren zur Herstellung eines photovoltaischen Umwandlungsmaterials nach Anspruch 4, bei dem die S-Quelle ein S-Pulver ist.


**Revendications**

**1.** Dispositif de conversion photovoltaïque, comprenant :

une couche d'absorption de lumière, la totalité ou une partie de la couche d'absorption de lumière incluant un composé à base de $Cu_2Ge_{1-x}Sn_xS_3$, **caractérisé en ce que** x est tel que 0,7 < x < 1.

**2.** Dispositif de conversion photovoltaïque selon la revendication 1, dans lequel le dispositif de conversion photovoltaïque présente une structure empilée d'une électrode inférieure, de la couche d'absorption de lumière, d'une couche tampon, d'une couche fenêtre et d'une électrode de grille.

**3.** Dispositif de conversion photovoltaïque selon la revendication 1, dans lequel le dispositif de conversion photovoltaïque présente une structure empilée de verre, de Mo, de la couche d'absorption de lumière, de CdS, de ZnO : Ga, et d'une électrode de grille Al.

**4.** Procédé de fabrication d'un matériau de conversion photovoltaïque, comprenant :

la préparation d'un précurseur à base de Cu ;
la génération d'une valeur contenant du S et du Ge à partir d'une source de S et d'une source de Ge ; et
la réaction de la vapeur avec le précurseur à base de Cu afin de synthétiser un matériau de conversion photovoltaïque incluant un composé à base de Cu-Ge-S, dans lequel la source de Ge est une poudre ou un film mince d'un ou de plusieurs matériaux sélectionnés parmi le GeS et le $Ges_2$.

**5.** Procédé de fabrication d'un matériau de conversion photovoltaïque selon la revendication 4, dans lequel le précurseur à base de Cu est un précurseur à base de Cu-Ge, un précurseur à base de Cu-Sn, ou un précurseur à base de Cu-Ge-Sn.

**6.** Procédé de fabrication d'un matériau de conversion photovoltaïque selon la revendication 4, dans lequel le précurseur à base de Cu est un précurseur à base de Cu-Sn ayant une composition de 1,6 < Cu/Sn, et le composé à base de Cu-Ge-S est un composé à base de $Cu_2Ge_{1-x}Sn_xS_3$ ayant une composition de 0,7 < x < 1.

**7.** Procédé de fabrication d'un matériau de conversion photovoltaïque selon la revendication 4, dans lequel le précurseur à base de Cu est un précurseur à base de Cu-Ge-Sn ayant une composition de 1,6 < Cu/(Ge+Sn) et 0,7 < Sn(Ge+Sn), et le composé à base de Cu-Ge-S est un composé à base de $Cu_2Ge_{1-x}Sn_xS_3$ ayant une composition de 0,7 < x < 1.

8. Procédé de fabrication d'un matériau de conversion photovoltaïque selon la revendication 4, dans lequel la source de S est une poudre de S.

[Fig. 1]

[Fig. 2]

[Fig. 3]

[Fig. 4]

[Fig. 5]

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 101330110 A

- US 20110303879 A1

**Non-patent literature cited in the description**

- **T. EISENBARTH et al.** *Thin Solid Films,* 2009, vol. 517, 2244

- **A/LUQUE.** *J.Appl.Phys.,* 2011, vol. 110, 031301